# EUROPEAN PATENT APPLICATION

(11) **EP 1 326 140 A1**
(43) Date of publication of application: **09.07.2003**
(21) Application number: 02102697.6
(22) Date of filing: 06.12.2002
(51) Int. Cl.: G03F 7/30

(54) **Resist development process**

(30) Priority: 03.01.2002 GB 0200039
(71) Applicant: Zarlink Semiconductor Limited, Swindon, Wiltshire SN2 2QW (GB)
(72) Inventor: Martin, Brian, PL6 6LQ, Plymouth (GB); Perring, John, PL9 7BL, Plymouth (GB)
(74) Representative: Asquith, Julian Peter

(57) **Abstract**

A method of removing exposed resist, comprises the steps of,
applying a first layer of developer to the surface of the resist for a first period of time;
substantially removing said first layer of developer from the surface of the resist;
applying a second layer of developer to the surface of the resist for a second period of time;
substantially removing said second layer of developer; and
applying at least a third layer of developer to the surface of the resist for a third period of time.

## Description

The invention relates to a method of removing exposed resist.

The invention seeks to improve the development of exposed resist in circuits having deep circuit topography.

According to the invention there is provided a method of removing resist, and an integrated circuit (IC) or MEMS (Micro Electrical and Mechanical Systems) device produced by such a method, as set out in the accompanying claims.

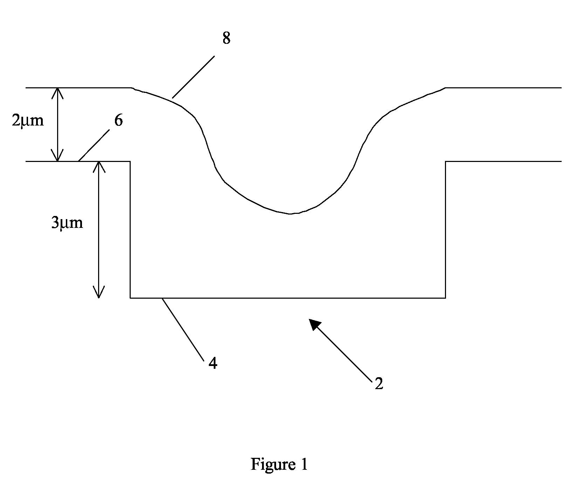

An embodiment of the invention will now be described, by way of example only, with reference to the accompanying Figure 1.

Figure 1 shows a layer of resist covering a well in a circuit topography.

Resist, normally photoresist, is conventionally developed, in a patterning process, from exposed areas of the surface of IC or MEMS devices by allowing developer to "dwell" on the wafer for periods of time typically 30-50 seconds. During that time the activity of the "puddle" of developer becomes depleted, or exhausted, as it dissolves the exposed resist.

In circumstances of severe topography where circuit architecture exhibits deep wells of the order of several microns, resist tends not to conform with the shape of the well and in extreme cases can be planarised over it. Therefore the developer is occasionally unable to remove all of the thicker resist in the deep well in its conventional single puddle cycle but it can still correctly control development in other parts of the circuit. Such development effects have been observed in MEMS circuits.

A MEMS circuit may be built on top of a conventional CMOS device. Deep wells of the MEMS structure may pass over underlying CMOS topography where there may be another well formed between adjacent features which further increases local resist thickness. In such a case the resist in the MEMS structure is thicker at the point where it passes over the CMOS well, and this may result in an area of undeveloped resist of variable thickness.

Figure 1 shows a well 2 defining lower and upper levels 4 and 6 respectively. A layer of resist 8 covers the well 2. The nominal thickness of the resist 8 is 2 microns. The difference between the lower and upper levels 4 and 6 is about 3 microns. The resist 8 is unable to conform exactly to the shape of the well 2, and the resist 8 therefore has a greater thickness above the lower level 4. The resist 8 is at its greatest thickness at the corners of the well 2, as shown in Figure 1.

Developer activity can be increased by applying a second charge of developer after removing the first depleted puddle of developer. The process sequence is then to remove the first charge of developer from the wafer, normally by a spin operation, and then to apply a second charge of developer in the same manner as the first.

Water rinses should not be used between the different charges of developer as they have the effect of arresting uniform development rates in the second phase.

In the present embodiment the development process is extended, observing similar intermediate conditions as between the first and second charges, by dispensing a third charge of developer. We refer to this as a triple develop process.

The first triple develop process tried was of cycles of 30 seconds (called standard triple develop) and was accompanied by a reduced exposure to uv light so as to maintain correct circuit dimensions. Thus there is a balance between exposure and development which relies on adjustment of exposure to produce correct circuit dimensions whilst allowing the triple development process to have sufficient activity to clear completely the "deep" parts of the circuit layout.

In the typical architecture experimented on, the triple 30 second development cycles partially cleared the resist residue but it was not completely clear until develop time was increased to 50 seconds in each cycle. We refer to this as and extended triple develop process.

## Claims

1. A method of removing exposed resist, comprising the steps of,
applying a first layer of developer to the surface of the resist for a first period of time;
substantially removing said first layer of developer from the surface of the resist;
applying a second layer of developer to the surface of the resist for a second period of time;
substantially removing said second layer of developer; and
applying at least a third layer of developer to the surface of the resist for a third period of time.

2. A method as claimed in claim 1, wherein one or more further layers of developer are applied to the resist, for one or more further periods of time, after the previous layer has been removed.

3. A method as claimed in any preceding claim, wherein said resist is a photoresist.

4. A method as claimed in any preceding claim, wherein said first period of time is about 30 seconds.

5. A method as claimed in any preceding claim, wherein said first period of time is about 50 seconds.

6. A method as claimed in claim 4 or 5, wherein said first, second and third periods of time are substantially equal.

7. A method as claimed in any preceding claim, wherein at least said first layer of developer is removed by spinning said resist.

8. A method as claimed in any preceding claim, wherein said resist covers the surface of an integrated circuit or MEMS device.

9. An integrated circuit or MEMS device when produced by a method including the steps of any preceding claim.
